# EUROPEAN PATENT SPECIFICATION

(11) **EP 2 978 872 B1**
(45) Date of publication and mention of the grant of the patent: **20.09.2017**
(21) Application number: 14716632.6
(22) Date of filing: 26.03.2014
(51) Int. Cl.: C23C 16/14, C23C 16/30, C23C 24/08, C09K 3/14, C04B 41/51

(54) **SUPERABRASIVE MATERIAL WITH PROTECTIVE ADHESIVE COATING AND METHOD FOR PRODUCING SAID COATING**
SUPERABRASIVES MATERIAL MIT EINER SCHUTZHAFTSCHICHT UND VERFAHREN ZUR HERSTELLUNG DIESER BESCHICHTUNG
MATÉRIAU SUPERABRASIF AVEC REVÊTEMENT ADHÉSIF PROTECTEUR ET PROCÉDÉ POUR PRODUIRE LEDIT REVÊTEMENT

(30) Priority: 27.03.2013 GB 201305637; 17.04.2013 US 201313864984
(43) Date of publication of application: 03.02.2016
(73) Proprietor: Hardide PLC, Bicester OX26 4UL (GB)
(72) Inventor: ZHUK, Yuri, Bicester Oxfordshire OX26 4UL (GB); LAKHOTKIN, Yuri, Bicester Oxfordshire OX26 4UL (GB)
(74) Representative: HGF Limited
(86) International application number: PCT/GB2014/050960
(87) International publication number: WO 2014/155109

(56) References cited:
- US-A- 5 346 719
- US-B1- 7 022 403
- US-B2- 6 524 357

## Description

This invention relates to coated diamond super-hard materials, a process for their coating and to coated diamonds for use in wear-resistant materials, hard facing and abrasive-containing tools.

### BACKGROUND

Diamond is the hardest known material, widely used in industry both in tools for cutting, drilling and other operations, and in parts subject to wear. However, diamond use and performance in these applications can be restricted by several properties of diamonds. Firstly, diamonds are difficult to attach to tools or wear parts, due to the chemical inertness of diamond and also its poor wettability by molten metals. Secondly, diamonds can be oxidised or graphitized at the elevated temperatures often encountered during the manufacture or operation of such tools or wear parts. Graphitization is the transformation of hard diamond into soft graphite, and occurs at elevated temperatures when diamond is in contact with nickel, cobalt, iron and other metals that are catalysts of the diamond graphitization process. These metal catalysts are often used during the manufacture of synthetic diamonds and when sintering polycrystalline diamonds, and also are present in the cemented carbide parts often used to support diamonds, for example in oil drill bits incorporating polycrystalline diamond cutters. When diamonds are in contact with these metals, they become susceptible to graphitization, and this limits the maximum temperatures at which these can be used to below 400 to 500°C. This not only limits the use of the diamond tools, but it also restricts the use of high temperature manufacturing processes such as casting, brazing, and thermal spraying often employed in the production of oil drilling tools, stone cutting saws and other diamond tools and wear parts. Molten iron-group metals can quickly dissolve diamond even through a limited contact area.

Previous attempts to use coatings to improve the retention of diamonds and at the same time to protect diamonds from oxidation and graphitization have not produced satisfactory results.

WO 2005/078041 (Element Six) discloses coated abrasives, which may comprise diamond or cubic boron nitride particles having a two-layer coating with thickness 0.05 to 10µm, preferably from 0.2 to 1µm. An inner layer of metal carbide, nitride or carbonitride, more specifically titanium carbide or chromium carbide, is used because of its good adhesion to diamond. The outer layer is tungsten physically deposited on top of the inner layer, mainly by the method of physical vapour deposition (PVD). Claim 5 states that no portion of the tungsten coating is carbided.

There are several drawbacks and features of the tungsten layer described in WO 2005/078041 which are associated with the physical method of the layer deposition, and in particular with the PVD method. Physically applied coating methods (involving sputtering, evaporation or ion beams) require direct line-of-sight access to the surface being coated. This means that an uneven and porous substrate will not be uniformly coated. The tungsten layer produced by these physical methods is thin (typically less than 1µm), porous, and its adhesion to the inner layer can be compromised due to the differences in their chemical composition and physical properties, such as thermal expansion mismatch. As a result such a layer cannot protect diamond from exposure to molten metals, such as cobalt, nickel or iron, which can form intermetallic compounds with tungsten, diffuse through the thin tungsten layer, and also penetrate via pores in the coating. Contact between diamond and molten cobalt, nickel or iron can cause diamond graphitization, as these metals are catalysts converting super-hard diamond into soft graphite. Insufficient adhesion between dissimilar inner and outer layers produced as described in WO 2005/078041 and mismatch in their thermal and mechanical properties can result in separation of the outer layer when exposed to mechanical or thermal stresses, which will further weaken the protective effect of such coatings. Delamination of the outer layer from the inner layer may result in diamond loss from the tool or wear part surface.

US 8,202,335 (US Synthetic Corp) claims a superabrasive element configured for brazing to a bit body of a drill bit, comprising a tungsten carbide layer being substantially free of binder material and consisting essentially of tungsten carbide, with thickness of about 5µm to about 100µm, preferably between 5µm and 60µm. Claim 11 states that the tungsten carbide layer is applied by chemical vapour deposition (CVD). The purpose of coating polycrystalline diamond is to enhance the diamond attachment to the drill bit by brazing.

The temperatures used for CVD tungsten carbide coating deposition, as well as the temperatures of other coating processes mentioned in the descriptive part of US 8,202,335 are typically below 600°C. This temperature is too low for tungsten diffusion across the boundary between tungsten carbide and diamond, so this does not allow a diffusion mechanism for forming a strong coating adhesion bond. Unlike metal tungsten, essentially pure tungsten carbide does not react with carbon at the tungsten carbide CVD process temperatures, and thus does not form a strong chemical bond between the tungsten carbide layer and the diamond substrate. As a result the bond between the tungsten carbide layer and the diamond is not strong enough for all applications.

Binder-free tungsten carbide made by CVD or by other methods (PVD, sintering) is a very brittle material, usually highly stressed due to the inherent CVD deposition stresses, which quickly increase as the coating thickness increases. In addition to these inherent stresses there will be high thermal stresses due to thermal expansion mismatch between diamond and tungsten carbide: the linear coefficient of thermal expansion of diamond is 1.2x10⁻⁶K⁻¹, while that for tungsten carbide is around three times higher at 4x10⁻⁶K⁻¹. As a result, the tungsten carbide layer will be under high tensile stress when the coated diamonds are cooled down to room temperature. Brittle binder-free tungsten carbide with a thickness of 5 to 100µm will tend to fracture due to these stresses and may possibly delaminate from the diamond as the weakly bonded boundary between the two materials becomes highly stressed. Any further thermal processing, high temperature and high pressure processing and other operations involving heating will further stimulate cracking of the coating due to cyclic loading of the brittle and highly stressed materials. Operations where molten metals are present such as brazing can introduce molten metals into these cracks due to the capillary effect. Oxygen can reach the diamond surface via micro-cracks and oxidize the diamond. As a result, the coating disclosed in US 8,202,335 will not protect diamonds from graphitization and other damage from molten metals or oxidation during the diamond attachment, brazing, metal spraying or other processing involving high temperatures.

US 6,524,357 (Saint-Gobain) describes coating a superabrasive from a metal oxide powder, preferably oxides of tungsten, vanadium, tantalum and molybdenum. Diamonds mixed with the metal oxide powder are heated in an inert atmosphere so that the metal is thermochemically reduced from the oxide by the superabrasive material (such as diamond), and then hydrogen treated to produce a very thin (typically 0.1µm) metal layer chemically bonded to at least a portion of the superabrasive surface. This metal layer is extremely thin and will not protect the diamond from oxidation or molten metal attack causing diamond graphitization.

US 5,024,680 (Norton Company) describes a coated diamond grit with the coating having a first layer consisting of vapour-deposited chromium carbide, chemically bonded to the diamond, with a thickness of preferably 0.05-0.4µm, and a second layer of an oxidation-resistant carbide-forming metal, preferably tungsten, tantalum or molybdenum, with a thickness of 5-15µm. A third layer of nickel, cobalt or iron can be deposited on top of the coating by an electrolytic or electroless plating process. This multi-layer coating structure, consisting of dissimilar materials with different chemical and thermal properties, will have weaker bonding between the layers. In particular, the adhesion of vapour-deposited tungsten to chromium carbide is usually poor, as is adhesion of electrolytic or electroless deposited nickel to tungsten. Failure of any of these inter-layer bonds and separation of the coating layers from each other or from diamond will lead to the loss of diamond grain or exposure of the diamond to oxidation or aggressive metals. The iron-group metals of the third layer increase the risk of diamond graphitization. The chromium carbide first layer is very thin and is not a good barrier against the diffusion of other metals. Most of the three-layer coating has a low hardness and does not sufficiently protect the diamond grit from mechanical abrasion or erosion.

US 5,346,719 (General Electric Company) describes a three-stage process developed to coat CVD diamonds, mainly used for electronic devices. At a first stage, an extremely thin layer of refractory metal (preferably tungsten) is formed by CVD, which is heat-treated at a second stage and finally an additional layer of the refractory metal is deposited by CVD. The initial metal layer preferably has a thickness of just 100-300 angstroms (or 0.01 to 0.03µm) and is produced by way of reduction of tungsten hexafluoride by hydrogen at a low pressure (preferably 0.1-1.0 torr) at a temperature of preferably 400-500°C for about 0.5-1.5 minutes. At these conditions the deposition of tungsten will be at an initial nucleation phase, when the extremely thin layer of tungsten will not be continuous, and will consist of separate "islands" of the coating separated by uncoated diamond surface areas. This layer is essential for the overall coating adhesion, and the non-continuous first layer will not provide a reliable and sufficiently strong adhesion bond of the coating to diamonds. The initial layer will contain higher amounts of fluorine due to the process conditions, firstly due to the low process temperature (450°C) and low pressure (0.5 torr). At these conditions the reaction of tungsten hexafluoride with hydrogen during the 30-90 seconds process will not be complete, leaving significant amounts of non-reduced tungsten fluorides embedded in the coating layer. The fluorine content at the initial nucleation stage of the deposition of the coating is further increased due to the physical-chemical processes of adsorption of tungsten hexafluoride on the surface porosity, defects and impurities. Taken together, these factors result in the fluorine content in the first layer being higher than optimal, and generally in excess of 0.3wt%. This excessive fluorine buried in the coating near the tungsten/diamond boundary will cause gradual degradation of the innermost tungsten layer, for example if the coated diamonds are used at elevated temperatures or in the presence of water or oxygen, which are typical operating conditions for diamond drill bits and tools. Remaining tungsten fluorides buried inside the coating may react with water or oxygen to produce soft and porous tungsten oxides and oxy-fluorides, thus further undermining adhesion bond strength of the coating.

In summary, the non-continuous "islands" of the first coating layer, having excess fluorine content, as described in US 5,346,719 might provide sufficient adhesion for producing metal electrical contacts on CVD diamonds for electronic devices, which operate without any mechanical loads, but the coating thus produced will not have a sufficiently strong adhesion bond for diamond applications involving high shear and other mechanical loads and impact, such as in diamond drill bits, diamond hard-facing and diamond tools. The heat treatment stage of coating CVD diamonds described in US 5,346,719 uses a high temperature of 990°C, which is acceptable for CVD diamonds, but would cause thermal degradation of polycrystalline sintered or monocrystalline synthetic diamonds containing residual metal catalysts. The final third stage involves coating with a refractory metal, which would not have sufficiently high hardness to resist abrasive or erosive conditions.

US 7,022,403 (Hardide) describes a thin single-layer or multi-layer coating on diamonds consisting of tungsten carbides of various stoichiometry, developed specifically to enhance diamond retention in a tool or on a component surface, and is not stated to have any protective properties to protect diamonds from oxidation and graphitization. The coating in US 7,022,403 includes ultra-thin layers of tungsten carbides, including tungsten mono-carbide WC, tungsten semi-carbide W₂C, tungsten sub-carbides W₃C and W₁₂C, and tungsten, each subsequent layer applied on top of the previous layer, with a total thickness from 0.1 to 10µm, alloyed with fluorine in the amount from 0.0004wt% to 0.3wt%. The coating can be made in one stage by a diffusion process from a tungsten-containing charge, when the tungsten carbide is formed using carbon from the diamond itself. Alternatively the coating can be made by CVD followed by annealing. In both methods the coating is deposited in a single stage, and this imposes some limitations on the coating thickness and other characteristics.

After extensive testing of the coatings produced in accordance with US 7,022,403, it was found that both the internal tungsten carbide layer and the external tungsten layer have structural and other properties which are not always optimal for the protection of coated diamonds against molten metals such as cobalt, nickel, iron and their alloys and also do not always protect sufficiently against erosive and abrasive media during diamond tool use. Molten metals often used in the production of diamond tools will form intermetallic compounds and diffuse through the thin tungsten carbide/tungsten coating to attack diamond and cause its graphitization. Thicker coatings produced according to US 7,022,403 have most of the coating thickness consisting of soft metal Tungsten, which can be abraded/eroded when the diamond tool is operated or exposed to erosive media such as drilling mud. Loss of the soft coating due to abrasion/erosion will weaken the retention of the diamond and can lead to loss of diamond and thus tool degradation.

Coatings according to US 7,022,403 include layers of brittle subcarbides W₃C and W₁₂C, which reduce the coating fracture toughness and impact-resistance, important for diamond tools. These coatings may contain excessive amounts of fluorine, up to 0.3wt%, which can be detrimental for the coating adhesion and protective properties, especially if coated diamonds are used at high temperatures in the presence of water or oxygen.

US 6,800,383 and US 2009/0117372 (Hardide) describe coatings developed as wear-resistant coatings for metal parts. These coatings have a structure and mechanical properties designed for metal parts, and thus are not optimal for the protection of diamond from oxidation, graphitization and mechanical erosion. One fundamental difference between the prior art Hardide coatings on metals and the newly-developed coating for diamonds is that metal substrates usually have higher thermal expansion coefficients than the tungsten/tungsten carbide coatings, while diamonds have lower thermal expansion coefficients. For example austenitic stainless steel has a linear coefficient of thermal expansion (CTE) between 14.4 and 17.3x10⁻⁶K⁻¹, tungsten/tungsten carbide coatings have a CTE of 3.8 to 4.3x10⁻⁶K⁻¹, while diamond has a CTE of 1.2x10⁻⁶K⁻¹. The coatings applied at elevated temperatures on metal substrates when cooled down to room temperature will have compressive stresses, as the substrate thermal contraction will be three to four times bigger than the coating contraction. The compressive stresses in the coating help achieve enhanced abrasion resistance, resistance to fracture and fatigue. The same coating applied on diamond will be under high tensile stress upon cooling due to the thermal expansion mismatch. As a result, coatings developed for metals may fracture when applied on diamonds. Optimal coatings for diamonds must have higher ductility, lower deposition stresses, and a different gradient structure as compared to coating for metals. Coatings developed for metal parts have strong chemical or metallurgical bonds to metals, which is not suitable when coating diamonds, where the adhesion bond has a different chemical nature and requires different coating methods to be used. The coatings for metal parts typically contain fluorine in amounts between 0.001wt% and 0.4wt%, in some cases from 0.005wt% to 0.5wt%. High fluorine contents are not optimal for coating diamonds, which should have lower amounts of fluorine. For these reasons, the coatings described in US 6,800,383 and US2009/0117372 are not optimally suited as either adhesive or protective coatings on diamonds and diamond-containing materials.

### BRIEF SUMMARY OF THE DISCLOSURE

Viewed from a first aspect, there is provided a coating on mono- or poly-crystalline diamond or diamond-containing material, the coating comprising a first adhesive layer formed directly on the diamond or diamond-containing material, the first layer comprising a mixture of tungsten and tungsten carbide alloyed with fluorine in an amount of 0.001 to 0.12wt% calculated on the total weight of the first layer; and a second protective layer formed on the first layer, the second layer comprising at least tungsten alloyed with fluorine in an amount of 0.001 to 0.12wt% calculated on the total weight of the second layer.

The second layer may comprise tungsten and tungsten carbide alloyed with fluorine in an amount of 0.001 to 0.12wt% calculated on the total weight of the second layer.

Coatings according to US 7,022,403 are alloyed with fluorine in an amount from 0.0004wt% to 0.3wt%. By way of extensive experimentation, the present applicant has surprisingly found that the adhesive, mechanical and protective properties of the coating are improved when the fluorine content is in a narrower range from 0.001wt% to 0.12wt%. A fluorine content below 0.001wt% was found to be insufficient to achieve the effect of enhancing tungsten reactivity and strengthening the mechanical and protective properties of the coating. A fluorine content above 0.12wt% was found to raise a risk of excess fluorine causing degradation of the adhesion and cohesion of the coating, especially if the coated diamonds are used at elevated temperatures and in the presence of water or oxygen.

The first layer typically has a finer crystalline structure than the second layer, which may help to provide improved protection for the underlying diamond.

Carbon in the tungsten carbide of the first layer will generally be derived from the diamond or diamond-containing material on which the first layer is formed, which helps to promote strong adhesion of the first layer to the diamond substrate.

The first and/or the second layers are preferably chemically-deposited layers as opposed to physically-deposited layers.

The first layer may include at least one of tungsten monocarbide (WC) and tungsten semicarbide (W₂C).

The first layer may have a thickness of 0.1 to 4µm.

The first layer may consist essentially of metal tungsten (W), tungsten monocarbide (WC) and tungsten semicarbide (W₂C), mixed in a composite layer, all alloyed with fluorine in an amount of 0.001 to 0.12wt%. In some embodiments, the first layer has a molar ratio of WC:W₂C:W in a range (1-100):(5-20):(1-100)

The second layer may include at least one of tungsten monocarbide (WC) and tungsten semicarbide (W₂C).

Preferred embodiments are characterised by an absence of brittle tungsten subcarbides such as W₃C and/or W₁₂C.

The second layer may include tungsten carbide nanoparticles dispersed in a matrix of metal tungsten, alloyed with fluorine in an amount of 0.001 to 0.12wt%.

The second layer may itself be formed as a plurality of alternating sublayers of tungsten carbide alloyed with fluorine and tungsten alloyed with fluorine. The sublayers of tungsten carbide alloyed with fluorine may each be less than 4µm in thickness. Alternatively, the second layer may itself be formed as a plurality of alternating sublayers of tungsten alloyed with fluorine, and tungsten carbide nanoparticles dispersed in a matrix of metal tungsten, alloyed with fluorine. The sublayers of tungsten carbide nanoparticles dispersed in a matrix of metal tungsten may each be less than 4µm in thickness. The sublayers may have a respective thickness ratio from 10:1 to 1:10.

The second layer may have a thickness of 0.5 to 500µm, preferably of 3 to 50µm.

The coating may be formed on diamond or diamond-containing material comprising diamond, mono-crystalline diamond, poly-crystalline diamond, diamond-silicon carbide composites or other diamond-containing materials substantially free from metal catalysts and is thermally stable at temperatures up to at least 800°C.

The diamond or diamond-containing material may be substantially completely coated. Alternatively, it may be substantially completely coated except for portions where it has been held during coating, for example by way of tongs, clamps, forceps or the like.

The first and second layers are preferably substantially free from through porosity and/or through cracks.

The first and second layers may together consist of 93.88 to 99.95wt% tungsten.

The first and second layers are preferably free from non-refractory binder materials.

The coating may have a hardness from 4.0 to 25GPa, preferably from 6 to 18GPa.

Viewed from a second aspect, there is provided a superabrasive element comprising mono- or poly-crystalline diamond or diamond-containing material coated with the coating of the first aspect.

Viewed from a third aspect, there is provided a cutting or drilling tool incorporating at least one superabrasive element of the second aspect.

Viewed from a fourth aspect, there is provided a method for producing a cutting or drilling tool of the third aspect, wherein the superabrasive element is attached to a tool substrate by wetting the second, protective layer of the coating with molten metal. The metal may be selected from the group comprising: cobalt, nickel, iron, copper, titanium, silver, gold, aluminium, indium and alloys containing at least two of these metals. The molten metal may be applied by way of infiltration, casting, brazing, spraying, welding, soldering, Hot Isostatic Pressing (HIP) or High Temperature High Pressure (HTHP) cycling.

Viewed from a fifth aspect, there is provided a method of applying a coating to a substrate comprising mono- or poly-crystalline diamond or diamond-containing material, wherein a first adhesive layer is formed directly on the substrate by a first stage chemical deposition process, the first layer comprising a mixture of tungsten and tungsten carbide alloyed with fluorine in an amount of 0.001 to 0.12wt% calculated on the total weight of the first layer and wherein a second protective layer is formed on the first layer by a second stage chemical deposition process, the second layer comprising at least tungsten alloyed with fluorine in an amount of 0.001 to 0.12wt% calculated on the total weight of the second layer.

The first stage chemical deposition process may comprise placing the substrate in a carbon-free solid powder medium comprising metallic tungsten powder and fluorides (the fluorides in an amount of 0.1 to 10wt%), heating in a vacuum or an inert gas atmosphere, and holding at a temperature of 800 to 1050°C for at least 10 minutes to form the first adhesive layer. Due to the extremely low vapour pressure of tungsten, it is not possible to apply this refractory metal coating by evaporation/condensation at temperatures that diamond can withstand without degradation. Instead, a tungsten fluoride diffusion process is used, and during this diffusion process treatment, tungsten fluorides are transferred through the vapour phase from the surfaces of tungsten particles to the surface of the diamond, where tungsten fluorides are reduced by carbon from the diamond surface, forming tungsten carbides as well as tungsten. This is a chemical process, involving formation and reduction of tungsten fluorides and tungsten carbides, where fluorine plays a key role as a transport agent. The composition and structure of the first coating layer are determined by the balance of the complex simultaneous and interconnected processes of tungsten transfer through the vapour phase, reduction of tungsten and formation of tungsten carbides. The optimal regimes for deposition of this first coating layer were developed via extensive experimentation, and included determining the process temperature, heating and cooling rates, pressure and composition of the solid powder medium best suited to achieve the target coating parameters.

Other chemical methods of producing the first coating layer can also be used, such as Chemical Vapour Deposition, electrolysis of molten salts of tungsten, and reaction of tungstic acid salts in the presence of fluorides.

In a CVD process, the first stage chemical deposition process may comprise placing the substrate in a gaseous medium comprising WF₆ and hydrogen at a volumetric ratio of tungsten hexafluoride to hydrogen from 0.6 to 0.1, at a temperature of 400 to 600°C and a pressure of 0.5 to 20kPa for at least 2 minutes to produce a layer of tungsten alloyed with fluorine in an amount from 0.001 to 0.12wt%, with a thickness of at least 0.1µm, followed by heat treatment at a temperature between 800°C and 1000°C for at least 10 minutes to form the first adhesive layer.

In an alternative CVD process, the first stage chemical deposition process may comprise placing the diamonds or diamond-containing substrate in a gaseous medium comprising WF₆ and hydrogen, at a temperature of 350 to 600°C and a partial pressure of 0.1 to 20kPa with a volumetric ratio between WF₆ and hydrogen ranging from 3:5 to 1:10 for at least 3 minutes to form the first coating layer. The resulting thin layer of tungsten alloyed with fluorine can then be heat treated at a temperature in excess of 800°C to achieve inter-diffusion of the tungsten metal and carbon from the diamond surface, and also a reaction between tungsten and carbon producing tungsten carbides.

The layer of tungsten alloyed with fluorine may be applied to a thickness up to 50µm.

Other chemical methods of producing the first coating layer have also been investigated, including electrolysis of molten salts of tungsten and the reaction of tungstic acid salts in the presence of fluorides. Electrolysis of triple fluoride eutectic LiF - NaF - KF was conducted in a rotating graphite crucible at a temperature of 760-780°C and a current density of 500 A/m². Other salt melts can also be used, such as wolframic melt 79% NaCl + 20% Na₂WO₄ + 1% Na₂CO₃. At 850°C and a current density up to 6000 A/m² a dense layer of Tungsten was produced with a thickness of 5-6µm in a single electrolysis cycle.

Tungsten layer deposition by a reaction of tungstic acid salts in the presence of fluorides uses a mixture of the salts KWO₄ and KF, which is applied on the surface of diamonds, and then heated in an atmosphere of inert gas with hydrogen to 500-1200°C. As a result of the reactions, a layer of tungsten oxide alloyed with fluorine is produced on the diamond surface. This tungsten oxide is then reduced by hydrogen to metal tungsten alloyed with fluorine. Fluorine is the most electronegative element with an extremely high electron affinity. When fluorine is present as an alloying element in optimal amounts, it reduces the temperature of the reduction of tungsten oxides by hydrogen. At the same time, carbon diffusion into tungsten and chemical reactions between carbon and tungsten result in the formation of tungsten carbides on the boundary between the diamond surface and the tungsten layer.

The first coating layer can also be produced by other methods, such as Physical Vapour Deposition (PVD), electrochemical and electroless deposition of tungsten from solutions.

By way of extensive experimentation conducted by the present Applicant, it was surprisingly found that to achieve optimal mechanical and chemical properties, the coating on diamonds should contain fluorine in amounts ranging from 0.001 to 0.12wt% calculated on the total weight of the first layer. In addition to acting as a tungsten transport agent, fluorine when present in optimal amounts enhances the reactivity of tungsten with carbon as well as the mechanical properties of tungsten. It is known that pure tungsten reacts with carbon (as graphite) to form tungsten carbides at temperatures above 1050°C in a process called carburization [Tungsten Properties, Chemistry, Technology of the Element, Alloys and Chemical Compounds, Erik Lassner, Wolf-Dieter Schubert, Kluwer Academic, 1999]. Pure tungsten also reacts with carbon (as diamond) above 1000°C, but this high temperature can cause diamond degradation, especially of polycrystalline sintered diamonds and synthetic diamond grit with residual catalysing metals. Because fluorine is the most electronegative element with one of the highest electron affinity values (3.45eV (340kJ/mole)) among chemical elements, it is considered to be the most powerful oxidizing element. By attracting electrons from surrounding atoms, such as tungsten atoms, fluorine increases the reactivity of tungsten and thus reduces the temperature of its chemical reactions, at least when fluorine is present as an alloying element in tungsten in an optimal concentration. From experimentation, it was found that a fluorine concentration below 0.001wt% is too low to have any significant effect on the reactivity of tungsten. Moreover, when fluorine is present in and amount more than 0.12wt%, it can cause undesirable chemical transformations to the tungsten, especially at elevated temperatures and in the presence of water or oxygen. Both the diffusion process of forming the first coating layer described in this application and other methods such as CVD followed by heat treatment were developed to achieve this optimal alloying concentration of fluorine between 0.001wt% and 0.12wt%. This allows enhanced reactivity of alloyed tungsten with diamond carbon to be achieved, and the production of tungsten carbides at lower temperatures in the range of 800 to 970°C. This lower formation temperature of tungsten carbides does not damage many of the grades of the industrial diamonds, such as diamond grit and TSP polycrystalline diamonds. The formation of tungsten carbides is essential to form strong chemical bonds between the tungsten coating and the diamond surface.

The amount of fluorine, as well as its dispersion and chemical state, in both tungsten and tungsten carbide coatings depends on the deposition process conditions, including the ratio of H₂ to WF₆, the temperature, pressure, velocity and turbulent/laminar character of the precursor mixture flow, the purity of the precursors, and the reactor size and shape. The overall CVD tungsten coating deposition reaction (WF₆+3H₂ = W+6HF) in fact goes through more than ten stages, starting with WF₆ adsorption on the substrate surface, followed by a series of physical-chemical transformations on the gas/solid boundary. By extensive experimentation, it was surprisingly found that to achieve optimal coating properties, fluorine must be uniformly dispersed in the tungsten or tungsten carbide matrix as an alloying element, and that individual fluorine atoms must form strong ionic-covalent chemical bonds with the tungsten or tungsten carbide. Accordingly, the process conditions were developed to achieve these results. For example, it was found that reactors and process conditions which form laminar flow of the gas mixture (such as tubular reactors with laminar flow of reactive gar precursors) do not achieve sufficiently quick mixing of the precursor gases, and will not result in the alloying of tungsten with fluorine to form strong chemical bonds. On the other hand, reactor and the process conditions which cause the gases entering the reactor to expand rapidly with turbulent flow achieve much better mixing of H₂ and WF₆, which have hugely different molecular masses. This surprising result, optionally with the use of optimised deposition conditions (temperature, pressure, flow velocity and others), enabled the present Applicant to obtain substantially pore-free deposits with alloying fluorine atoms present in the optimal concentration between 0.001wt% and 0.12wt%, uniformly dispersed in the tungsten or tungsten carbide matrix and strongly bonded via ionic-covalent bonds inside the tungsten crystalline lattice. This composition was surprisingly found to have improved stability. The uniformly dispersed fluorine atoms chemically bonded in the tungsten matrix via hybrid ionic-covalent bonds serve to strengthen the crystalline structure of tungsten, while also immobilising the fluorine. This composition is different from other non-optimal tungsten-fluorine materials, where fluorine is simply present as a non-alloyed inclusion. These non-optimal materials can be unstable due to reactions forming volatile products, especially in the presence of oxygen and at elevated temperatures. For example, fluorine in a different chemical state may react with tungsten at room temperature producing volatile tungsten fluoride reaction products, and this reaction can continue without the formation of a protective layer. In the presence of air or water, this reaction can produce tungsten oxy-fluorides which can escape or evaporate until one of the reagents is exhausted or can form defects in the material structure. Tungsten oxy-fluorides, oxides and fluorides do not have high hardness, and inclusions of these substances in tungsten or tungsten carbide coatings can become stress concentration points and/or initiate inter-granular and fatigue cracks when the coating is deformed or stressed, and as a result can weaken the mechanical properties of the coating. Thus the fluorine concentration, its uniform dispersion and its chemical state are all important for producing stable alloyed tungsten and tungsten carbide coatings with optimal properties. This is true for both the first and the second layers of the coating disclosed in this application.

The second stage chemical deposition process may comprise placing the substrate coated with the first adhesive layer in a gaseous medium comprising WF₆, hydrogen and optionally hydrocarbons, at a temperature of 350 to 600°C and a partial pressure of 0.1 to 20kPa for at least 10 minutes to form the second protective layer.

At least one of the coatings may be deposited by way of vapour phase deposition, the vapour being non-ionized and chemically active during the deposition process, with the substrate being moved during the deposition process so as to obtain complete coating over the entire substrate surface.

The substrate may comprise diamond or diamond-containing grit or elements.

In certain embodiments, diamond grains and polycrystalline diamond parts are coated with a thick (typically up to 100µm) pore-free coating which contains both tungsten and tungsten carbides, applied by a chemical method such as Chemical Vapour Deposition (CVD) (in contrast to the physical deposition method of WO 2005/078041). Due to the crystallization of the coating from the gas phase, CVD methods allow uniform coating of complex shapes and porous surfaces, such as polycrystalline diamond parts, with the coating even penetrating inside the pores and sealing smaller pores. During the CVD coating crystallization of tungsten and tungsten carbide, tungsten atoms produced on the growing surface as a result of chemical reactions have high mobility, thus filling the low energy positions in the coating structure, producing a substantially pore-free layer. This coating has significantly better protective properties against molten metals and other aggressive media.

Unlike the coating of WO 2005/078041, the coating of embodiments of the present application always contains tungsten carbides, first of all as an innermost layer of the coating formed using carbon from the diamond surface and thus forming a strong chemical adhesion bond. Some coating variants may also include tungsten carbide dispersed in a metal tungsten matrix and layers of tungsten carbide disposed between layers of tungsten.

The present Applicant has undertaken extensive experimentation and testing, and has found that the optimal coating for diamonds should have sufficient thickness to protect the diamond against aggressive metals, be free from brittle tungsten subcarbide phases, and especially should avoid deposition of these phases as continuous layers prone to fracture failure. The internal layer of the optimal coating should have a composite structure rather than a layered structure. The composite structure preferably consists of a dispersed mixture of all three phases: tungsten monocarbide WC, tungsten semicarbide W₂C and metal tungsten; this gives the coating the combination of enhanced toughness with high hardness. The external layer of an optimal coating must have sufficient hardness to resist abrasion/erosion. All these conclusions resulted in the development of the new protective adhesive coating disclosed in this application.

The coating of the present application has been developed to help protect the diamond from oxidation and also from attack by aggressive metal bonds, such as cobalt, nickel or iron, which have catalytic properties and can cause diamond conversion into soft graphite - an effect called "graphitization" - which is detrimental to the diamond wear resistance. The coating is intended to enhance diamond retention within tools, as the innermost layer of the coating has a strong chemical bond to the diamond, and its external layer has good wettability with molten metal bonds, brazing and casting alloys used in diamond tools.

Coatings of the present application can be used (without limitation) to protect monocrystalline diamonds, diamond grit, polycrystalline diamonds, Thermally Stable Products (TSP), diamond-silicon carbide composite elements, silicon cemented diamond and other diamond-containing materials, which thermally stable at a temperature of at least 800°C.

By way of extensive experimentation, it was surprisingly found that to provide optimal protection for diamonds and diamond-containing materials, the coating ideally required a combination of properties and characteristics, including the following:
1. Strong adhesion bond of the coating to diamond.
2. The coating method should achieve continuous coating of the majority of the grain surface of the diamond grit or the whole surface of polycrystalline diamond parts.
3. Sufficient thickness and suitable structure to prevent diffusion of molten metals to the diamond.
4. The coating should be substantially free from porosity and micro-cracks, which can let oxygen or molten metals attack the diamond.
5. The coating should have a coefficient of thermal expansion (CTE) close to the CTE of diamond or the diamond-containing material to reduce stresses.
6. Sufficient hardness to resist mechanical abrasion, but also enhanced toughness and ductility to prevent brittle failure and micro-cracking of the coating during mechanical or thermal shocks.
7. The external surface of the coating should have good wettability by molten metal binders, brazing and casting alloys.
None of the prior art coatings meets all the above listed requirements.

The coating of embodiments of the present application, which was developed after extensive experimentation, consists of partially-carbided tungsten, alloyed with fluorine. Methods of producing this coating achieve a strong chemical bond of the coating to the coated diamonds, by forming a layer of tungsten carbide formed by the chemical reaction of tungsten with carbon from the diamond surface.

The methods enable the production of thick coatings with thicknesses up to 150µm, in some cases up to 500µm, substantially free from porosity and micro-cracks. These thick and pore-free coatings form a strong barrier against diamond oxidation or diffusion of molten metals which can cause diamond graphitization.

Some prior art methods of coating diamonds (e.g. WO 2005/078041) use physical vapour deposition (PVD) techniques which can coat only line-of-sight areas and are not able to coat inside pores with a high aspect ratio of pore depth to diameter. Some polycrystalline diamond materials, such as TSP diamonds or fully-leached polycrystalline diamond disks, can have very deep pores with intricate shapes when the catalysing metal binder used to produce these polycrystalline parts is leached off. Other prior art methods for coating diamonds (e.g. US 7,022,403) or metal parts (e.g. US 6,800,383 and US2009/0117372) allow the coating of stationary parts, with some areas used to support these parts during coating deposition remaining uncoated. The resulting porosity in the coating or the uncoated areas do not provide the necessary degree of protection against oxidation and molten metals, which can penetrate through the coating porosity and cause diamond graphitization.

To resolve this problem, the method of chemical deposition or CVD was found most suitable to produce the required thick, pore-free coating. Chemical deposition allows conformal coating of non-line-of-sight areas, including deep intricate pores. In one embodiment, the superabrasive elements are moved at certain stages of the coating deposition, thus enabling these elements to be coated over all or most of their surface, for example with at least 90% of the total surface area being coated.

Some embodiments of the coatings of the present application combine enhanced hardness with toughness. This is necessary to protect diamond elements from erosion during the metal-spraying processes often used during hard-facing, and also from abrasion and erosion of the diamond-containing hard facing during its operation, for example on an oil drilling tool.

US 7,022,403 discloses a single-stage coating deposition process, using either a diffusion method or a CVD coating deposition with subsequent annealing. Single-stage coating depositions can usually only produce thin coatings (typically a few micrometres, maximum 10µm) which may not give sufficient protection for the diamond. Such coatings may also have non-optimal composition and structure, since the single-stage coating deposition does not provide full flexibility in controlling or modifying the coating characteristics.

The coating of embodiments of the present application has two layers: an inner adhesive layer with a strong chemical adhesion bond to diamond, and an outer protective layer. These layers may be produced in two separate processes: the inner adhesive layer can be produced by a diffusion method or by a CVD process followed by heat treatment, and the outer protective layer can be produced by a chemical method, such as Chemical Vapour Deposition (CVD). This allows the building of much thicker coatings with significantly lower internal stresses due to thermal expansion mismatch. Using two separate coating deposition processes also provides much better control over the phase composition and structure of each of the two layers, which can be optimised independently from each other as detailed below.

The inner adhesive layer, which is applied directly on the diamond or diamond-containing material, may consist essentially of tungsten monocarbide (WC), tungsten semicarbide (W₂C) and metal tungsten, mixed in a composite layer, all alloyed with fluorine present in an amount of 0.001 to 0.12wt%. Extensive experimentation determined that the adhesive layer was advantageously free from tungsten subcarbide phases W₃C and W₁₂C, which have poor mechanical properties, are brittle and have high residual stresses. The inner adhesive layer may be produced by a diffusion method, which may be optimised to achieve a target layer composition and structure. In particular, in order to prevent or at least suppress the formation of brittle subcarbide phases W₃C and W₁₂C, the diffusion process temperature should be at least 800°C.

A solid powder medium charge may be used to produce the inner adhesive layer, the charge containing metal tungsten powder and fluorides in an amount from 1 to 10%wt. This not only enables the formation of the inner adhesive layer in a composition free from brittle tungsten subcarbide phases, but also enables an improved structure for the inner layer to be realised. The coating for diamonds disclosed in US 7,022,403 provides an inner adhesive layer with a layered phase structure, including a first innermost layer of tungsten monocarbide WC, a second layer of tungsten semicarbide W₂C deposited over the first layer, further layers of tungsten subcarbides W₃C and W₁₂C over the previous layers, and finally a layer of metal tungsten. It has been found that this layered structure may not always have ideal mechanical properties, and in some implementations can be brittle and have high mechanical stresses. The present coating, in contrast, has a composite structure where different phases (including WC, W₂C and metal tungsten) are mixed together rather than layered on top of each other. This mixed composite structure allows coating hardness and mechanical strength to be combined with enhanced toughness and ductility. In addition, there is a reduction in mechanical and thermal expansion mismatch stresses during deposition of the coating and the use of diamonds coated with the coating. After extensive experimentation, appropriate regimes of producing the inner adhesive layer were developed, result in a coarser morphology of the newly-developed inner adhesive layer. Unlike the smooth morphology of the previously patented layered coating (US 7,022,403), this coarser morphology provides a stronger adhesion bond to diamonds and diamond-containing materials and also provides a keying surface for a stronger adhesion bond of the external protective layer to the inner layer. The inner adhesion layer is still finer than the external protective layer, but coarser than the layer of US 7,022,403.

The outer, protective layer of the present coating is produced mainly or substantially by way of chemical deposition, which in contrast to physical deposition methods allows a continuous and uniform coating of the majority of the superabrasive element surface to take place, including coating inside open pores. Polycrystalline diamonds, such as Thermally Stable Product (TSP), can be sintered from diamond grit using catalysing metals usually from the iron group, such as nickel, cobalt or iron, which act as a solvent during sintering to fuse individual diamond grains together. Catalysing metal that may remain in the interstitial pores between the sintered diamond grains can then be leached away to improve the thermal stability of the TSP. Catalyst-free TSP diamonds can withstand temperatures in excess of 1000°C, which would cause diamond graphitization if the metal catalyst remained in contact with diamond. TSP diamonds are sometimes infiltrated with a non-catalysing filler, such as silicon, but their surfaces tend to remain uneven and porous, and difficult to attach to a metal tool body. Preferred embodiments of the present coating are substantially pore-free and crack-free, and have sufficient thickness to seal the interstitial porosity in the polycrystalline diamonds and diamond-containing materials. This prevents infiltration of the molten metal binder (such as brazing alloy, cobalt binder, metal infiltrant alloys) into the interstitial pores. Consequently, this can enhance the thermal stability of polycrystalline diamond tools, as most of these metal binders have thermal expansion coefficients (TECs) substantially higher than the TEC of diamond, and can mechanically rupture the polycrystalline diamond at elevated temperatures.

Thermal metal spraying is often used as part of the process for attaching diamonds as hard-facing on the surface of oil drilling string stabilizers. To protect diamonds from oxidation and also from mechanical erosion by the sprayed molten metal, the coating should have sufficient erosion resistance. Coated polycrystalline superabrasives on the wear surfaces of oil drilling tools and in other applications are exposed to highly abrasive and erosive conditions, for example being abraded against rock formations and being exposed to high velocity flows of drilling mud carrying sand and stone chippings. The coated polycrystalline superabrasives are also exposed to impact and shock loads. If the coating is not able to resist these abrasive and erosive conditions, or is too brittle and fractures under shock load, then the coated superabrasive element can be lost. Erosion and abrasion resistance of the coating are important when diamonds with thick protective coatings are used in diamond tools, since selective erosion or abrasion of the coating layer can gradually form a gap between the diamond and the tool matrix, and this gap can weaken retention of the diamond and can lead to loss of the diamond. In order better to resist erosion and abrasion, the coating should combine enhanced hardness with toughness and ductility. This combination of hardness with toughness has been found by the present Applicant to give the best overall protection resisting various mechanisms of wear and erosion: the enhanced hardness inhibits micro-cutting mechanisms of wear and erosion, while the coating toughness and ductility prevent fatigue micro-cracking/chipping and platelet mechanisms of erosion. Extremely hard but brittle materials such as binder-free tungsten carbide are likely to fail due to brittle fracture, and are known to fail in erosive conditions under high angles of attack due to micro-cracking. Tough and ductile materials with low hardness are known to fail under low angle erosion due to micro-cutting actions, and are expected to wear in abrasive environments. Thermo-mechanical stresses due to thermal expansion/contraction mismatch between the coating and the substrate, as well as thermal shock combined with mechanical impact during metal spraying, also require sufficient ductility and toughness of the coating, as brittle coatings are likely to fracture.

Toughness and ductility of the coating are also essential for applications where diamond tools can suffer from shock loads and impact, such as oil drilling tools. Brittle coatings such as pure tungsten carbide can fracture after impact. Even a micro-crack can become a stress concentrator when the tool is used with high shear loads applied to diamonds, and can quickly develop through the brittle coating material, resulting in separation of the diamond from the tool. Loss of one such superabrasive element can increase the mechanical shear load on the neighbouring elements. Such loss can also interrupt the cutting action and increasing shock loads on the next most exposed superabrasive element, which then becomes more likely to fail, leading to a "domino" effect and premature failure of the whole hard-facing area.

To resist these conditions, an optimal coating should combine sufficient hardness to resist abrasive wear with enhanced toughness and ductility to resist impact. By way of extensive experimentation and testing, it was found that coatings including both tungsten carbide and metal tungsten in predetermined proportions and also with certain material structures, may demonstrate such a combination of properties. Tungsten carbide provides enhanced hardness and metal tungsten provides toughness and ductility. To achieve improved performance, these composite protective coatings of embodiments of the present application can have one of two specific structures.

In one embodiment the coating has a layered structure with alternating thin layers consisting predominantly of metal tungsten and of tungsten carbide or a mixture of tungsten with tungsten carbides. The overall hardness and toughness of the layered coating can be controlled by adjusting the thicknesses of the individual layers, their ratios and the phase composition of individual layers. In preferred embodiments, excellent protective properties can be achieved with a ratio of the thicknesses of individual tungsten and tungsten carbide-containing layers ranging from 1:10 to 10:1. The total thickness of these coatings can be up to 50µm, in some cases up to 100µm, and in some cases where extremely thick coatings are required up to 500µm, and the overall hardness of this type of multi-layer coating can be in the range from 4 to 25GPa, preferably 6 to 18GPa.

In another embodiment, the coating comprises tungsten carbide nano-particles dispersed in a metal tungsten matrix. In this embodiment, the overall hardness and toughness of the composite coating can be controlled by varying the amount of tungsten carbide nano-particles, along with their size and phase composition. Preferred embodiments have excellent protective properties when the hardness is in the range of 6 and 18GPa, and the coating thickness up to 100µm, in some cases where extremely thick coating is required up to 500µm.

The coatings for diamonds disclosed, for example, in US 7,022,403 and WO 2005/078041 generally have a thinner (typically less than 10µm) outer layer made of physically-deposited tungsten that is free of tungsten carbides. This does not provide the same resistance to abrasive wear and erosion, nor does it provide the same degree of protection of the coated diamonds from attacks by molten metals.

Preferred embodiments of the present invention always have at least two different layers, deposited in two separate processes. This allows the structure, the composition and the properties of each layer to be optimised, as they have different functions: the internal layer is adhesive and the external layer is protective. The internal layer has no single-phase layers (in contrast to US 7,022,403), instead it has a fine-grained composite structure and always comprises both tungsten and tungsten carbide (or both WC and W₂C) mixed together within the layer. This composite structure has significantly better impact-resistance, and ensures enhanced cohesion between the layers and adhesion to a superabrasive substrate.

In comparison to the coatings disclosed in US 5,346,719, the coatings of the present disclosure have a number of distinguishing features:

| | US 5,346,719 | Present disclosure (first adhesive layer applied by CVD) |
|---|---|---|
| Coated Substrate | CVD Diamond sheets | Mono- or poly-crystalline diamond or diamond-containing material |
| Thickness of the first layer | 10-10,000 Angstroms (0.001-1µm), preferably 200 Angstroms (0.02µm) | 0.1-4µm |
| Ratio of WF₆/H₂ | 1:12 | From 3:5 to 1:10 |
| Heat treatment T | 700°C to 1200°C | 800°C to 1000°C |
| CVD temperature | 300 to 700°C | 400 to 600°C |
| CVD pressure | 0.1 torr to 3 torr (0.013 - 0.4 kPa) Preferably 0.5 torr (0.065 kPa) | 0.5-20 kPa |
| Fluorine content | Not specified | 0.001wt% to 0.12wt% |
| | At the process conditions described above the fluorine content is likely to be outside the range from 0.001wt% to 0.12wt% | |
| External layer composition | Tungsten | Tungsten alloyed with fluorine, in some embodiments also contains tungsten carbides WC, W₂C |

The different process conditions, and the different thickness and composition of the present coating, are to achieve complete coverage of a diamond surface with tungsten alloyed with a specified amount of fluorine.

### BRIEF DESCRIPTION OF THE DRAWINGS

Embodiments of the invention are further described hereinafter with reference to the accompanying drawings, in which:
Figure 1 is an X-ray diffraction spectrum for a first stage coating layer described in Example 1;
Figure 2 an X-ray diffraction spectrum for a second coating layer after the second stage coating described in Example 1, the second layer comprising predominantly pure tungsten;
Figure 3 an X-ray diffraction spectrum for a second coating layer after a second stage coating described in Example 9, the second layer comprising metal tungsten, tungsten monocarbide WC and tungsten semicarbide W₂C;
Figure 4 is a scanning electron microscope image of a fracture cross-section of a coated TSP polycrystalline diamond as described in Example 1;
Figure 5 is a scanning electron microscope image of a fracture cross-section of an alternative coated TSP polycrystalline diamond (as described in Example 3);
Figure 6 shows a selection of coated TSP polycrystalline diamond elements, as described in Example 3 and
Figure 7 an X-ray diffraction spectrum for a first coating layer described in Example 9.

### DETAILED DESCRIPTION

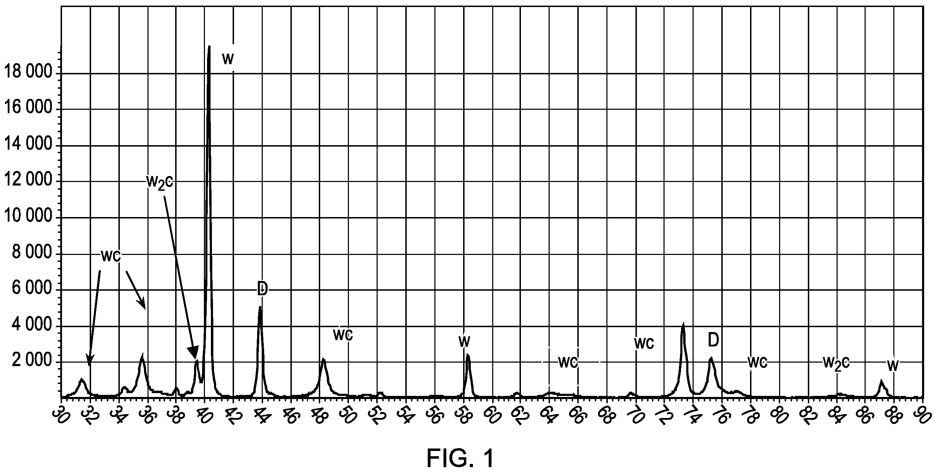

Figure 1 shows an X-ray diffraction (XRD) spectrum of a first layer, adhesive coating with thickness 0.9µm as described in Example 1 below. This first layer coating consists of a mixture of metal tungsten W with tungsten carbides W₂C and WC. Because the coating is thin, the X-ray diffraction instrument also records the diamond substrate lines marked "D". This XRD spectrum is typical for the first adhesive coating layer as described in the present application.

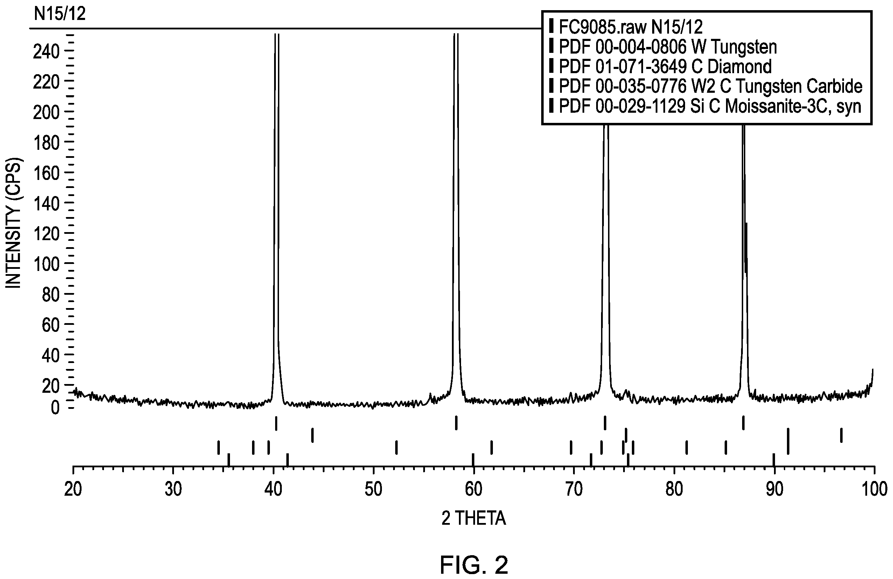

Figure 2 shows a typical XRD pattern for a two-layer coating having a second, protective layer of substantially pure tungsten alloyed with fluorine having a thickness of around 20µm. The positions of the characteristic lines of the following materails are shown beneath the spectrum:
Top row: Tungsten W;
Second row: Diamond C;
Third row: Tungsten Carbide W₂C;
Fourth row: Silicon Carbide SiC.
Because the second coating layer is relatively thick, neither the diamond or SiC substrate lines nor the tungsten carbide lines from the first coating layer are visible.

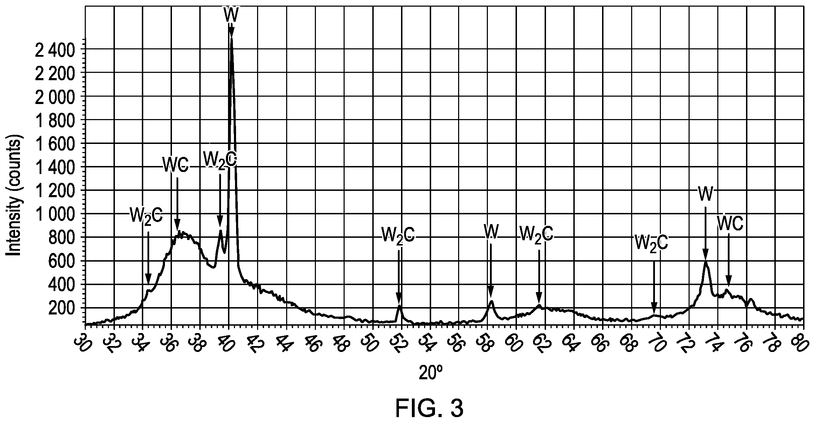

Figure 3 shows a typical XRD pattern for a two-layer coating with the second, protective layer comprising a multi-layer coating of W+W₂C+WC with a thickness of 16.5µm, as described in Example 9. Again, because the second layer is relatively thick, diamond substrate lines are not visible in the spectrum.

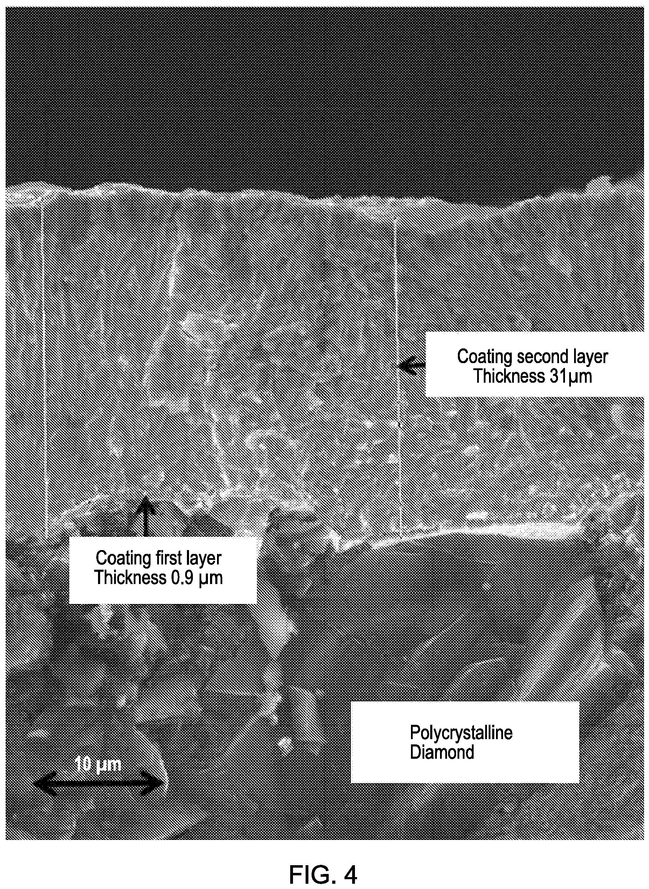

Figure 4 is a scanning electron microscope (SEM) image of the fracture cross-section of a coated TSP polycrystalline diamond as described in Example 1 below. The coating comprises two layers. There is a first, adhesive layer with a thickness of 0.9µm, having a fine microstructure, and consisting of a composite of tungsten with tungsten carbides, alloyed with fluorine. Overlaid on the first layer is a second, protective layer with a thickness of 31µm, having a coarser columnar microstructure, and consisting of metal tungsten alloyed with fluorine.

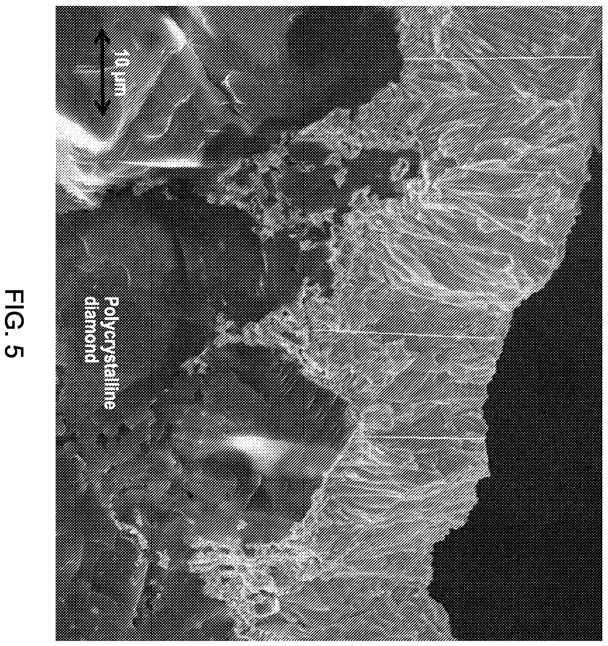

Figure 5 is an SEM image of the fracture cross-section of an alternative coated TSP polycrystalline diamond. The coating comprises two layers. There is a first, adhesive layer with a fine microstructure, consisting of a composite of tungsten with tungsten carbides, alloyed with fluorine with thickness 0.8 µm. Overlaid on the first layer is a second, protective layer with a thickness of 30 to 27µm, having a coarser columnar microstructure, and consisting of metal tungsten alloyed with fluorine. The coating has a strong adhesion bond to diamonds, as demonstrated by the fact that it remains adhered even after fracture of the coated diamond. The coating has a dense structure, free from porosity, and fills gaps and indentations in the uneven and porous surface of the polycrystalline diamond.

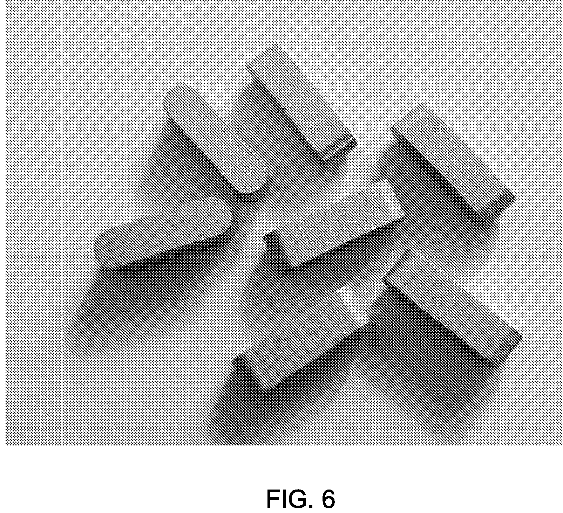

Figure 6 is a photograph of coated TSP polycrystalline diamond elements as described in Example 3. The elements are uniformly coated all over, and have a silvery metal colour, with the external coating layer consisting of tungsten alloyed with fluorine.

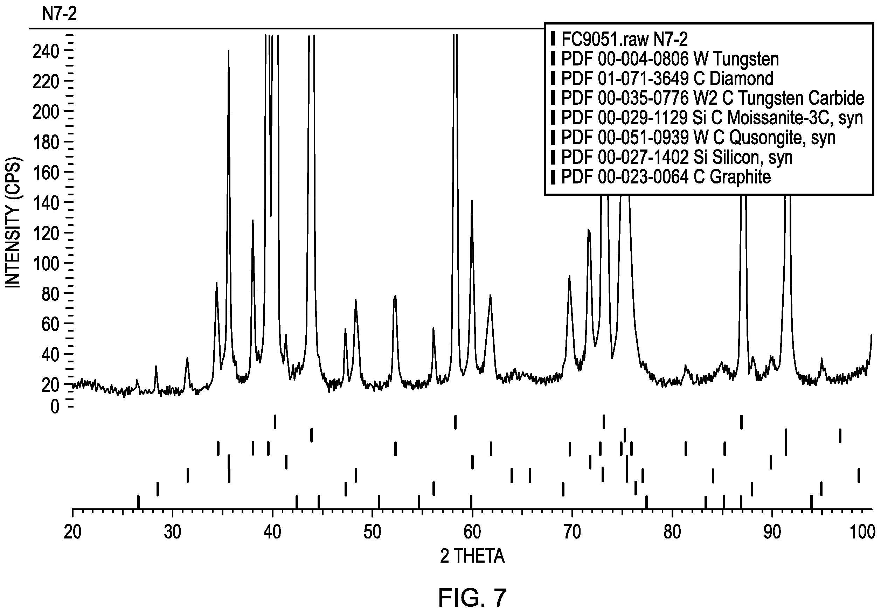

Figure 7 shows a typical XRD pattern for the first layer coating produced as described in Example 9, the coating consists of a mixture of pure tungsten with Tungsten carbides WC and W₂C, alloyed with fluorine having a thickness of around 1.5µm. The positions of the characteristic lines of the following materails are shown beneath the spectrum in the following order:
Tungsten W;
Diamond C;
Tungsten Carbide W₂C;
Silicon Carbide SiC;
Tungsten Carbide WC;
Silicon Si
Graphite C.
Because the first coating layer is relatively thin, the spectrum has the lines characteristic for both the substrate (Diamond, SiC, Si) and for the coating (Tungsten, Tungsten carbides WC and W₂C).

### Examples

### Example 1

Sintered TSP (Thermally Stable Polycrystalline Diamond) superabrasive diamond elements are mixed with a powdered tungsten metal charge with a fluorine content of 0.12wt%, in a volume proportion of 1:6. The mixture is heated in a vacuum (0.013Pa) at a temperature of 930°C for 1.5 hours. As a result of this process, an adhesive layer is produced on diamond elements with a thickness of 0.9µm and a roughness of 0.07µm. The adhesive layer consists of a mixture of WC, W₂C and W, with a fluorine content of 0.025wt%. The ratio of the WC, W₂C and W phases is 1:1:3. Figure 1 shows the XRD spectrum of these coated TSP diamonds, showing lines both for the diamond substrate and for the WC, W₂C and W phases of the coating. The tungsten carbides in the coating were produced using carbon from the TSP diamond surface, which reacted with the tungsten in the powdered charge; there is no other source of carbon used in this process.

In order to provide the second, protective coating, the diamond elements with the adhesive coating are loaded into a CVD reactor chamber and kept in a reactive gas mixture of WF₆ and H₂ mixed in a volumetric proportion of 1:25 at a temperature of 550°C and total pressure of 2kPa for 2 hours. As a result of this second stage process, a second, protective coating layer is deposited. The second, protective coating layer consists substantially of tungsten alloyed with fluorine in an amount 0.015wt% with a thickness of 31µm and a hardness of 6GPa. Figure 2 shows the XRD spectrum of these TSP diamonds coated with a two layer coating. The spectrum shows only lines for tungsten, and does not have the lines characteristic for diamond and the tungsten carbide phases WC and W₂C. The second layer of the coating consists predominantly of tungsten alloyed with fluorine and is too thick to enable the XRD instruments detect characteristic lines of diamond or tungsten carbides from the first coating layer.

The two coating layers on the TSP diamonds together have a total thickness of 31.9µm. The SEM image of the cross-section of the coated TSP diamond element is shown on Figure 4. Both coating layers are visible, with the second thick layer having a coarse columnar structure, while the thin first layer has a much finer micro-crystalline structure.

### Example 2

Natural diamond monocrystals with sizes 20-30 crystals per carat are mixed with a powdered metal tungsten charge with an inert filler and with a fluorine content of 0.9wt%, in a volume proportion of diamond:tungsten:filler of 1:6:0.5. The mixture is heated in a vacuum (0.013Pa) at a temperature of 970°C for 1 hour. As a result of this process, an adhesive layer is produced on the diamonds with a thickness of 1.3µm and a roughness of 0.1µm. The adhesive layer consists of a mixture of WC, W₂C and W, with a fluorine content of 0.014wt%. The ratio of the WC, W₂C and W phases is 2:1:3.

In order to provide the second, protective coating, the diamond elements with the adhesive coating are loaded into a CVD reactor chamber and kept in a reactive gas mixture of WF₆ and H₂ mixed in a volumetric proportion of 1:20 at a temperature of 450°C and a total pressure of 4kPa for 1.5 hours. As a result of this second stage process, a second, protective coating layer is deposited. The second, protective coating layer consists of tungsten alloyed with fluorine in an amount of 0.008wt% with a thickness of 13µm and a hardness of 6.7GPa. Together, the two coating layers have a total thickness of 14.3µm.

### Example 3

Sintered TSP superabrasive diamond elements and a powdered tungsten metal charge with a fluorine content of 0.25wt% are mixed in a volumetric proportion of 1:8. The mixture is heated in a vacuum (0.013Pa) at a temperature of 830°C for 2.5 hours. As a result of this process, an adhesive layer is produced on the diamond elements with a thickness of 0.8µm. The adhesive layer consists of a mixture of WC, W₂C and W, with a fluorine content of 0.036wt%. The ratio of the WC, W₂C and W phases is 1:2:2.

In order to provide the second, protective coating, the diamond elements with the adhesive coating are loaded into a CVD reactor chamber and kept in a reactive gas mixture of WF₆ and H₂ mixed in a volumetric proportion of 1:15 at a temperature of 600°C and a total pressure of 2kPa for 2.5 hours. The diamond elements were moved during the coating process, to ensure uniform coating all over. As a result of this second stage process, a second, protective coating layer is deposited. The second, protective coating layer consists of tungsten alloyed with fluorine in an amount of 0.009wt% with a thickness of 20-27µm and a hardness of 5.8GPa. Together, the two coating layers have a total thickness of 21-28µm. The coated TSP diamond elements are shown in Figure 6.

One sample of the coated TSP diamond was broken for coating analysis, the cross section of one such element being shown in Figure 5. The sintered polycrystalline diamond substrate has an uneven rough surface, and the coating covers the diamond surface completely, filling the gaps and crevices between the diamond grains. The innermost coating layer adjacent to the diamond surface has a finer micro-crystalline structure, while the outer coating layer has a coarser columnar micro-structure. Both coating layers contain tungsten, and the first layer additionally contains tungsten carbides. Both tungsten carbides and tungsten have low thermal expansion coefficients, closer to the thermal expansion coefficient of diamond, as compared to most other metals used in coatings for diamonds, such as titanium, chromium and nickel. The similarity of the chemical composition of both coating layers, as well as their thermal and mechanical properties, facilitate strong cohesion between the two layers and reduce the thermal mismatch and inherent stresses in the coatings. The coated TSP diamond element shown in Figure 4 has the two coating layers clearly visible, but when the element was broken for analysis, the two layers remained strongly bonded together and adhered to the diamond surface. The fracture did not show any steps or gaps between the first and the second coating layers, nor were any areas of coating missing.

The coated TSP diamond elements were tested for brazing, using the following brazing alloys:

| **Brazing alloy** | **Composition Percent** | **Liquidus T°C** | **Solidus T°C** | **Brazing T°C** | **Results** |
|---|---|---|---|---|---|
| CB4 | Ag - 70.50 | 850 | 780 | 900°C | Good wetting |
| | Cu - 26.50 | | | | |
| | Ti - 3.00 | | | 950°C | Good wetting |
| TiCuSil | Ag - 68.8 | | 780 | 900°C | Good wetting |
| | Cu - 26.7 | | | | |
| | Ti - 4.5 | | | 950°C | Good wetting |
| CuSil | Ag - 63.0 | 815 | 780 | 900°C | Good wetting |
| | Cu - 35.25 | | | | |
| | Ti - 1.75 | | | 950°C | Good wetting |
| InCuSil | Ag - 59.0 | | 605 | 900°C | Good wetting |
| | Cu - 27.25 | | | | |
| | In - 12.5 | | | 950°C | Poor wetting |
| | Ti - 1.25 | | | | |

Each alloy was tested at two brazing temperatures, 900°C and 950°C, for 5 minutes. Most of the brazed elements showed good wetting of the coating by the brazing alloy and formation of a strong brazing bond, except for InCuSil samples brazed at the higher temperature of 950°C, which failed to wet the coating surface.

### Example 4

Sintered polycrystalline superabrasive diamond disks, fully leached from metal catalyst, are mixed with a powdered metal tungsten charge with an inert filler containing 0.7wt% of fluorine, in a volume proportion diamond:tungsten:filler of 1:6:0.6. The mixture is heated in a vacuum (0.013Pa) at a temperature of 950°C for 2 hours. As a result of this process, an adhesive layer is produced on the diamond discs with a thickness of 2.0µm and a roughness of 0.12µm. The adhesive layer consists of a mixture of WC, W₂C and W, with a fluorine content of 0.055wt%. The ratio of the WC, W₂C and W phases is 1.5:1:3.

In order to provide the second, protective coating, the diamond elements with the adhesive coating are loaded into a CVD reactor chamber and kept in a reactive gas mixture of WF₆ and H₂ mixed in a volumetric proportion of 1:12 at a temperature of 550°C and a total pressure of 2kPa for 1.5 hours. As a result of this second stage process, a second, protective coating layer is deposited. The second, protective coating layer consists of tungsten alloyed with fluorine in an amount of 0.006wt% with a thickness of 24µm and a hardness of 5.7GPa. Together, the two coating layers on the fully-leached PDC diamond disks have a total thickness of 26µm.

The coated diamond disks were attached to cemented carbide WC/Co substrates using a High Temperature High Pressure press cycle. Molten cobalt metal binder from the substrate wetted the coated disk surface providing a strong bond. The thick two-layer coating provided a strong barrier against cobalt infiltration, so that the cobalt did not come into direct contact with the diamond surface. This prevented diamond graphitization catalysed by cobalt, and the coating therefore enhanced the thermal stability of the attached polycrystalline diamond disks.

### Example 5

Synthetic diamond grit with grain sizes 400-315 microns is mixed with a powdered metal tungsten charge with a fluorine content of 0.3wt%, in a volumetric proportion of 1:8. The mixture is heated in a vacuum (0.013Pa) at a temperature of 930°C for 1.5 hours. As a result of this process, an adhesive layer is produced on the diamonds with a thickness of 1.0µm and a roughness of 0.07µm. The layer consists of a mixture of WC, W₂C and W, with a fluorine content of 0.017wt%. The ratio of the WC, W₂C and W phases is 1:1:3.

In order to provide the second, protective coating, the diamond elements with the adhesive coating are loaded into a CVD reactor chamber and kept in a reactive gas mixture of WF₆, H₂ and a hydrocarbon gas mixed in a volumetric proportion of 15:54:1 at a temperature of 500°C and a total pressure of 2kPa for 40 minutes. As a result of this second stage process, a second, protective coating layer is deposited. The second, protective coating layer consists of a tungsten metal matrix with dispersed tungsten carbide nanoparticles, alloyed with fluorine in an amount 0.008wt% with a thickness of 25µm and a hardness of 14.8GPa.

Together, the two coating layers have a total thickness of 26µm.

### Example 6

Sintered polycrystalline TSP diamonds are mixed with a powdered metal tungsten charge with an inert filler with a fluorine content of 0.9wt%, in a volume proportion of diamonds:tungsten:filler of 1:8:0.7. The mixture is heated in a vacuum (0.013Pa) at a temperature of 900°C for 2 hours. As a result of this process, an adhesive layer is produced on diamonds with a thickness of 1.0µm and a roughness of 0.05µm. The adhesive layer consists of a mixture of WC, W₂C and W, with a fluorine content of 0.046wt%. The ratio of the WC, W₂C and W phases is 1:2:3.

In order to provide the second, protective coating, the diamond elements with the adhesive coating are loaded into a CVD reactor chamber and kept in a reactive gas mixture of WF₆, H₂ and a hydrocarbon gas mixed in a volumetric proportion of 11:40:1 at a temperature of 520°C and a total pressure of 2kPa for 30 minutes. As a result of this second stage process, a second, protective coating layer is deposited. The second, protective coating layer consists of a tungsten metal matrix with dispersed tungsten carbide nanoparticles, alloyed with fluorine in an amount 0.012wt% with a thickness of 17µm and a hardness of 17.5GPa. Together, the two coating layers on the TSP diamonds have a total thickness of 18µm.

### Example 7

Sintered polycrystalline diamond disks, fully leached from metal catalyst, are mixed with a powdered tungsten metal charge with a fluorine content of 0.4wt%, in the volume proportion of diamondsaungsten of 1:7. The mixture is heated in a vacuum (0.013Pa) at a temperature of 950°C for 2 hours. As a result of this process, an adhesive layer is produced on the diamond disks with a thickness of 2.5µm and a roughness of 0.15µm. The layer consists of a mixture of WC, W₂C and W, with a fluorine content of 0.026wt%. The ratio of the WC, W₂C and W phases in the coating layer is 1.5:1:3.

In order to provide the second, protective coating, the diamond elements with the adhesive coating are loaded into a CVD reactor chamber and kept in a reactive gas mixture of WF₆, H₂ and at some stages a hydrocarbon gas mixed in a volumetric proportion of 20:70:1 at a temperature of 520°C and a total pressure of 2kPa for a total of 90 minutes. The flow of the hydrocarbon gas was switched on and off for alternating periods of 5 minutes. As a result, the second coating layer is deposited as a layered structure, with alternating layers of tungsten and layers of tungsten metal matrix with dispersed tungsten carbide nanoparticles. Nine pairs of layers in total are deposited, all layers being alloyed with fluorine in an amount 0.017wt%. The total thickness of the second coating is 50µm, including tungsten layers each approximately 3µm thick and layers of tungsten metal matrix with dispersed tungsten carbide nanoparticles each approximately 2µm thick. The overall hardness of the coating is 12.0GPa. Together, the two coating layers on the diamond disks have a total thickness of 52µm.

### Example 8

Synthetic diamond grit with grain sizes 400-315 microns is mixed with a powdered metal tungsten charge with a fluorine content of 0.2wt%, in a volume proportion of 1:8. The mixture is heated in a vacuum (0.013Pa) at a temperature of 850°C for 2 hours. As a result of this process, an adhesive layer is produced on the diamonds with a thickness 0.8µm and a roughness of 0.05µm. The layer consists of a mixture of WC, W₂C and W, with a fluorine content of 0.015wt%. The ratio of the WC, W₂C and W phases is 1:2:3.

In order to provide the second, protective coating, the diamond elements with the adhesive coating are loaded into a CVD reactor chamber and kept in a reactive gas mixture of WF₆, H₂ and a hydrocarbon gas mixed in a volumetric proportion of 22:77:1 at a temperature of 510°C and a total pressure of 2kPa for 40 minutes. As a result of this second stage process, a second, protective coating layer is deposited. The second, protective coating layer consists of a tungsten metal matrix with dispersed tungsten carbide nanoparticles, alloyed with fluorine in an amount 0.008wt% with a thickness of 20µm and a hardness of 11.0GPa. Together, the two coating layers have a total thickness of 20.8µm.

### Example 9

TSP polycrystalline diamond elements were loaded in a CVD reactor chamber and kept in a reactive gas mixture of WF₆, and H₂ mixed in a volumetric proportion of 1:2 at a temperature of 590°C and a total pressure of 2kPa for 30 minutes. As a result of this first stage process, a layer of tungsten alloyed with fluorine is deposited, with a thickness of 1.5µm. The coated diamond elements were then heated in a vacuum (0.013Pa) to a temperature of 920°C for 2 hours. As a result of this process, an adhesive layer is produced on the diamonds with a thickness 1.5µm. The layer consists of a mixture of WC, W₂C and W, with a fluorine content of 0.024wt%. The X-ray diffraction spectrum of these diamond elements is shown in Figure 7, demonstrating a layer comprising metal tungsten, tungsten monocarbide WC and tungsten semicarbide W₂C, with spectra of diamond, silicon and silicon carbide from the sintered TSP polycrystalline diamond substrate. The ratio of the W/W₂C/WC phases based upon measuring the peak intensities of the three peaks for W, W₂C and WC is 45:5:1.

In order to provide the second, protective coating, the diamond elements with the adhesive coating are loaded into a CVD reactor chamber and kept in a reactive gas mixture of WF₆, H₂ and a hydrocarbon gas mixed in a volumetric proportion of 2:7:2 at a temperature of 510°C and a total pressure of 2kPa for 47 minutes. As a result of this second stage process, a second, protective coating layer is deposited. Figure 3 shows an X-ray diffraction spectrum of the coated diamond elements. The second, protective coating layer consists of a mixture of tungsten with tungsten carbides WC and W₂C, alloyed with fluorine in an amount 0.008wt% with a thickness of 15µm and a hardness of 21.0GPa. Together, the two coating layers have a total thickness of 16.5µm.

Throughout the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

The reader's attention is directed to all papers and documents which are filed concurrently with or previous to this specification in connection with this application and which are open to public inspection with this specification.

## Claims

1. A coating on mono- or poly-crystalline diamond or diamond-containing material, the coating comprising a first adhesive layer formed directly on the diamond or diamond-containing material, the first layer comprising a mixture of tungsten and tungsten carbide alloyed with fluorine in an amount of 0.001 to 0.12wt% calculated on the total weight of the first layer; and a second protective layer formed on the first layer, the second layer comprising at least tungsten alloyed with fluorine in an amount of 0.001 to 0.12wt% calculated on the total weight of the second layer.

2. A coating as claimed in claim 1, wherein the second layer comprises tungsten and tungsten carbide alloyed with fluorine in an amount of 0.001 to 0.12wt% calculated on the total weight of the second layer.

3. A coating as claimed in claim 1 or 2, wherein the first layer has a finer crystalline structure than the second layer.

4. A coating as claimed in any preceding claim, wherein carbon in the tungsten carbide of the first layer is derived from the diamond or diamond-containing material on which the first layer is formed.

5. A coating as claimed in any preceding claim, wherein the first and/or the second layer is a chemically-deposited layer.

6. A coating as claimed in any preceding claim, wherein the first layer includes at least one of tungsten monocarbide (WC) and tungsten semicarbide (W₂C).

7. A coating as claimed in any preceding claim, wherein the first layer consists essentially of metal tungsten (W), tungsten monocarbide (WC) and tungsten semicarbide (W₂C), mixed in a composite layer, all alloyed with fluorine in an amount of 0.001 to 0.12wt%.

8. A coating as claimed in any preceding claim, wherein the second layer includes at least one of tungsten monocarbide (WC) and tungsten semicarbide (W₂C).

9. A coating as claimed in any preceding claim, wherein the second layer includes tungsten carbide nanoparticles dispersed in a matrix of metal tungsten, alloyed with fluorine in an amount of 0.001 to 0.12wt%.

10. A coating as claimed in any preceding claim, wherein the second layer is itself formed as a plurality of alternating sublayers of tungsten alloyed with fluorine and either tungsten carbide alloyed with fluorine or tungsten carbide nanoparticles dispersed in a matrix of metal tungsten, alloyed with fluorine.

11. A coating as claimed in claim 10, wherein the sublayers have a respective thickness ratio from 10:1 to 1:10.

12. A coating as claimed in any preceding claim, wherein the second layer has a thickness of 0.5 to 500µm, optionally wherein the second layer has a thickness of 3 to 50µm.

13. A coating as claimed in any preceding claim, formed on diamond or diamond-containing material comprising diamond, mono-crystalline diamond, poly-crystalline diamond, diamond-silicon carbide composites or other diamond-containing materials substantially free from metal catalysts and being thermally stable at temperatures up to at least 800°C.

14. A coating as claimed in any preceding claim, wherein the first and second layers are substantially free from through porosity and/or through cracks.

15. A coating as claimed in any preceding claim, wherein the first and second layers together consist of 93.88 to 99.95wt% tungsten.

16. A superabrasive element comprising mono- or poly-crystalline diamond or diamond-containing material coated with the coating of any preceding claim.

17. A cutting or drilling tool incorporating at least one superabrasive element as claimed in claim 16.

18. A method for producing a cutting or drilling tool as claimed in claim 17, wherein the superabrasive element is attached to a tool substrate by wetting the second, protective layer of the coating with molten metal.

19. A method according to claim 18, wherein the metal is selected from the group comprising: cobalt, nickel, iron, copper, titanium, silver, gold, aluminium, indium and alloys containing at least two of these metals.

20. A method according to claim 18 or 19, wherein the molten metal is applied by way of infiltration, casting, brazing, spraying, welding, soldering, Hot Isostatic Pressing (HIP) or High Temperature High Pressure (HTHP) cycling.

21. A method of applying a coating to a substrate comprising mono- or poly-crystalline diamond or diamond-containing material, wherein a first adhesive layer is formed directly on the substrate by a first stage chemical deposition process, the first layer comprising a mixture of tungsten and tungsten carbide alloyed with fluorine in an amount of 0.001 to 0.12wt% calculated on the total weight of the first layer and wherein a second protective layer is formed on the first layer by a second stage chemical deposition process, the second layer comprising at least tungsten alloyed with fluorine in an amount of 0.001 to 0.12wt% calculated on the total weight of the second layer.

22. A method according to claim 21, wherein the first stage chemical deposition process comprises either:
i) placing the substrate in a carbon-free solid powder medium comprising metallic tungsten powder and fluorides in an amount of 0.1 to 10wt%, heating in a vacuum or an inert gas atmosphere, and holding at a temperature of 800 to 1050°C for at least 10 minutes to form the first adhesive layer; or
ii) placing the substrate in a gaseous medium comprising WF₆ and hydrogen at a volumetric ratio of tungsten hexafluoride to hydrogen from 0.6 to 0.1, at a temperature of 400 to 600°C and a pressure of 0.5 to 20kPa for at least 2 minutes to produce a layer of tungsten alloyed with fluorine in an amount from 0.001 to 0.12wt%, with a thickness of at least 0.1µm, followed by heat treatment at a temperature between 800°C and 1000°C for at least 10 minutes to form the first adhesive layer.

23. A method according to claim 22, wherein the layer of tungsten alloyed with fluorine is applied to a thickness up to 100µm.

24. A method according to claim 22 or 23, wherein the second stage chemical deposition process comprises placing the substrate coated with the first adhesive layer in a gaseous medium comprising WF₆, hydrogen and optionally hydrocarbons, at a temperature of 350 to 600°C and a partial pressure of 0.1 to 20kPa for at least 10 minutes to form the second protective layer.

25. A method according to any one of claims 21 to 24, wherein at least one of the coatings is deposited by way of vapour phase deposition, the vapour being non-ionized and chemically active during the deposition process, with the substrate being moved during the deposition process so as to obtain complete coating over the entire substrate surface.

## Patentansprüche

1. Beschichtung auf einem mono- oder polykristallinen Diamanten oder einem Diamant enthaltendem Material, wobei die Beschichtung eine erste Haftschicht, die direkt auf dem Diamanten oder dem Diamant enthaltenden Material gebildet wird, wobei die erste Schicht eine Mischung aus Wolfram und Wolframcarbid in Legierung mit Fluor in einer Menge von 0,001 bis 0,12 Gew.-%, berechnet bezogen auf das Gesamtgewicht der ersten Schicht, umfasst, und eine zweite Schutzschicht, die auf der ersten Schicht gebildet wird, umfasst, wobei die zweite Schicht zumindest Wolfram in Legierung mit Fluor in einer Menge von 0,001 bis 0,12 Gew.-%, berechnet bezogen auf das Gesamtgewicht der zweiten Schicht, umfasst.

2. Beschichtung nach Anspruch 1, wobei die zweite Schicht Wolfram und Wolframcarbid in Legierung mit Fluor in einer Menge von 0,001 bis 0,12 Gew.-%, berechnet bezogen auf das Gesamtgewicht der zweiten Schicht, umfasst.

3. Beschichtung nach Anspruch 1 oder 2, wobei die erste Schicht eine feinere kristalline Struktur aufweist als die zweite Schicht.

4. Beschichtung nach einem der vorhergehenden Ansprüche, wobei Kohlenstoff in dem Wolframcarbid der ersten Schicht von dem Diamant oder dem Diamant enthaltenden Material, auf dem die erste Schicht gebildet wird, erhalten wird.

5. Beschichtung nach einem der vorhergehenden Ansprüche, wobei die erste und/oder die zweite Schicht eine chemisch abgeschiedene Schicht ist.

6. Beschichtung nach einem der vorhergehenden Ansprüche, wobei die erste Schicht Wolframmonocarbid (WC) und/oder Wolframsemicarbid (W₂C) umfasst.

7. Beschichtung nach einem der vorhergehenden Ansprüche, wobei die erste Schicht im Wesentlichen aus Metallwolfram (W), Wolframmonocarbid (WC) und Wolframsemicarbid (W₂C) besteht, die in einer Verbundschicht gemischt sind und alle mit Fluor in einer Menge von 0,001 bis 0,12 Gew.-% legiert sind.

8. Beschichtung nach einem der vorhergehenden Ansprüche, wobei die zweite Schicht Wolframmonocarbid (WC) und/oder Wolframsemicarbid (W₂C) umfasst.

9. Beschichtung nach einem der vorhergehenden Ansprüche, wobei die zweite Schicht Wolframcarbidnanoteilchen, die in einer Matrix aus Metallwolfram dispergiert sind, in Legierung mit Fluor in einer Menge von 0,001 bis 0,12 Gew.-% umfasst.

10. Beschichtung nach einem der vorhergehenden Ansprüche, wobei die zweite Schicht selbst als mehrere abwechselnde Unterschichten von Wolfram in Legierung mit Fluor und entweder Wolframcarbid in Legierung mit Fluor oder Wolframcarbidnanoteilchen, die in einer Matrix aus Metalltungsten dispergiert sind, in Legierung mit Fluor, gebildet ist.

11. Beschichtung nach Anspruch 10, wobei die Unterschichten ein jeweiliges Dickenverhältnis von 10:1 bis 1:10 aufweisen.

12. Beschichtung nach einem der vorhergehenden Ansprüche, wobei die zweite Schicht eine Dicke von 0,5 bis 500 µm aufweist, gegebenenfalls wobei die zweite Schicht eine Dicke von 3 bis 50 µm aufweist.

13. Beschichtung nach einem der vorhergehenden Ansprüche, die auf einem Diamant oder einem Diamant enthaltenden Material ausgebildet ist, der bzw. das Diamant, monokristallinen Diamant, polykristallinen Diamant, Diamant-Siliciumcarbid-Verbundstoffe oder andere Diamant enthaltende Materialien, die im Wesentlichen frei von Metallkatalysatoren sind und bei Temperaturen von bis zu mindestens 800°C thermisch stabil sind, umfasst.

14. Beschichtung nach einem der vorhergehenden Ansprüche, wobei die erste und die zweite Schicht im Wesentlichen frei von Porosität und/oder durchgehenden Rissen sind.

15. Beschichtung nach einem der vorhergehenden Ansprüche, wobei die erste und die zweite Schicht zusammen aus 93,88 bis 99,95 Gew.-% Wolfram bestehen.

16. Superschleifelement, das mono- oder polykristallinen Diamant oder Diamant enthaltendes Material, der bzw. das mit der Beschichtung aus einem der vorhergehenden Ansprüche beschichtet ist, umfasst.

17. Zerspan- oder Bohrwerkzeug, das mindestens ein Superschleifelement wie in Anspruch 16 beansprucht enthält.

18. Verfahren zum Herstellen eines Zerspan- oder Bohrwerkzeugs nach Anspruch 17, wobei das Superschleifelement an einem Werkzeugsubstrat angebracht wird, indem die zweite Schutzschicht der Beschichtung mit geschmolzenem Metall benetzt wird.

19. Verfahren nach Anspruch 18, wobei das Metall ausgewählt ist aus der Gruppe umfassend Cobalt, Nickel, Eisen, Kupfer, Titan, Silber, Gold, Aluminium, Indium und Legierungen, die mindestens zwei dieser Metalle enthalten.

20. Verfahren nach Anspruch 18 oder 19, wobei das geschmolzene Metall mittels Einsickern, Gießen, Hartlöten, Sprühen, Schweißen, Weichlöten, Heißisostatischem Pressen (HIP) oder Hochtemperatur-Hochdruck-Zyklen (HTHP) aufgebracht wird.

21. Verfahren zum Aufbringen einer Beschichtung auf ein Substrat, das einen mono- oder polykristallinen Diamanten oder Diamant enthaltendes Material umfasst, wobei eine erste Haftschicht mittels einer ersten Phase eines chemischen Abscheidungsverfahrens direkt auf dem Substrat gebildet wird, wobei die erste Schicht eine Mischung aus Wolfram und Wolframcarbid in Legierung mit Fluor in einer Menge von 0,001 bis 0,12 Gew.-%, berechnet bezogen auf das Gesamtgewicht der ersten Schicht, umfasst, und wobei eine zweite Schutzschicht mittels einer zweiten Phase eines chemischen Abscheidungsverfahrens auf der ersten Schicht gebildet wird, wobei die zweite Schicht zumindest Wolfram in Legierung mit Fluor in einer Menge von 0,001 bis 0,12 Gew.-%, berechnet bezogen auf das Gesamtgewicht der zweiten Schicht, umfasst.

22. Verfahren nach Anspruch 21, wobei die erste Phase des chemischen Abscheidungsverfahrens eines der Folgenden umfasst:
i) Platzieren des Substrats in einem kohlenstofffreien festen Pulvermittel, das metallisches Wolframpulver und Fluoride in einer Menge von 0,1 bis 10 Gew.-% umfasst, Erhitzen in einem Vakuum oder einer inerten Gasatmosphäre und Halten bei einer Temperatur von 800 bis1050°C für mindestens 10 Minuten, um die erste Haftschicht zu bilden; oder
ii) Platzieren des Substrats in einem gasförmigen Medium, das WF₆ und Wasserstoff in einem volumetrischen Verhältnis von Wolframhexafluorid zu Wasserstoff von 0,6 zu 0,1 umfasst, bei einer Temperatur von 400 bis 600°C und einem Druck von 0,5 bis 20 kPa mindestens 2 Minuten lang, um eine Schicht von Wolfram in Legierung mit Fluor in einer Menge von 0,001 bis 0,12 Gew.-% mit einer Dicke von mindestens 0,1 µm zu erzeugen, gefolgt von Wärmebehandlung bei einer Temperatur zwischen 800°C und 1000°C mindestens 10 Minuten lang, um die erste Haftschicht zu bilden.

23. Verfahren nach Anspruch 22, wobei die Schicht von Wolfram in Legierung mit Fluor in einer Dicke von bis zu 100 µm aufgebracht wird.

24. Verfahren nach Anspruch 22 oder 23, wobei die zweite Phase des chemischen Abscheidungsverfahrens das Platzieren des Substrats, das mit der ersten Haftschicht beschichtet ist, in einem gasförmigen Medium, das WF₆, Wasserstoff und gegebenenfalls Kohlenwasserstoffe umfasst, bei einer Temperatur von 350 bis 600°C und einem Partialdruck von 0,1 bis 20 kPa mindestens 10 Minuten lang umfasst, um die zweite Schutzschicht zu bilden.

25. Verfahren nach einem der Ansprüche 21 bis 24, wobei mindestens eine der Beschichtungen mittels Dampfphasenabscheidung abgeschieden wird, wobei der Dampf während des Abscheidungsverfahrens nicht-ionisiert und chemisch aktiv ist, wobei das Substrat während des Abscheidungsverfahrens bewegt wird, um eine vollständige Beschichtung über die gesamte Substratfläche hinweg zu erhalten.

## Revendications

1. Revêtement sur un diamant mono ou polycristallin ou un matériau contenant du diamant, ledit revêtement comprenant une première couche adhésive formée directement sur le diamant ou le matériau contenant du diamant, ladite première couche comprenant un mélange de tungstène et de carbure de tungstène allié avec du fluor en une quantité de 0,001 à 0,12 % en poids calculée sur le poids total de la première couche ; et une seconde couche protectrice formée sur la première couche, ladite seconde couche comprenant au moins du tungstène allié avec du fluor en une quantité de 0,001 à 0,12 % en poids calculée sur le poids total de la seconde couche.

2. Revêtement selon la revendication 1, ladite seconde couche comprenant du tungstène et du carbure de tungstène allié avec du fluor en une quantité de 0,001 à 0,12 % en poids calculée sur le poids total de la seconde couche.

3. Revêtement selon la revendication 1 ou 2, ladite première couche possédant une structure cristalline plus fine que la seconde couche.

4. Revêtement selon l'une quelconque des revendications précédentes, ledit carbone dans le carbure de tungstène de la première couche étant dérivé du diamant ou du matériau contenant du diamant sur lequel la première couche est formée.

5. Revêtement selon l'une quelconque des revendications précédentes, ladite première et/ou ladite second couche étant une couche déposée chimiquement.

6. Revêtement selon l'une quelconque des revendications précédentes, ladite première couche comprenant au moins un parmi le mono-carbure de tungstène (WC) et le semi-carbure de tungstène (W₂C).

7. Revêtement selon l'une quelconque des revendications précédentes, ladite première couche étant constituée essentiellement de tungstène métallique (W), de mono-carbure de tungstène (WC) et de semi-carbure de tungstène (W₂C), mélangés dans une couche composite, tous alliés avec du fluor en une quantité de 0,001 à 0,12 % en poids.

8. Revêtement selon l'une quelconque des revendications précédentes, ladite seconde couche comprenant au moins un parmi le mono-carbure de tungstène (WC) et le semi-carbure de tungstène (W₂C).

9. Revêtement selon l'une quelconque des revendications précédentes, ladite seconde couche comprenant des nanoparticules de carbure de tungstène dispersées dans une matrice de tungstène métallique, allié avec du fluor en une quantité de 0,001 à 0,12 % en poids.

10. Revêtement selon l'une quelconque des revendications précédentes, ladite seconde couche étant elle-même formée comme une pluralité de sous-couches alternées de tungstène allié avec du fluor et soit du carbure de tungstène allié avec du fluor soit des particules de carbure de tungstène dispersées dans une matrice de tungstène métallique allié avec du fluor.

11. Revêtement selon la revendication 10, lesdites sous-couches possédant un rapport d'épaisseurs respectives allant de 10:1 à 1:10.

12. Revêtement selon l'une quelconque des revendications précédentes, ladite seconde couche possédant une épaisseur de 0,5 à 500 µm, éventuellement ladite seconde couche possédant une épaisseur de 3 à 50 µm.

13. Revêtement selon l'une quelconque des revendications précédentes, formé sur du diamant ou un matériau contenant du diamant comprenant du diamant, du diamant monocristallin, du diamant polycristallin, des composites de carbure de silicium-diamant ou d'autres matériaux contenant du diamant pratiquement exempte de catalyseurs métalliques et étant thermiquement stable à des températures atteignant au moins 800°C.

14. Revêtement selon l'une quelconque des revendications précédentes, lesdites première et seconde couches étant pratiquement exemptes de porosité traversante et/ou de fissures traversantes.

15. Revêtement selon l'une quelconque des revendications précédentes, lesdites première et seconde couches étant constituées ensemble de 93,88 à 99,95 % en poids de tungstène.

16. Élément super-abrasif comprenant du diamant mono ou polycristallin ou un matériau contenant du diamant revêtu avec le revêtement selon l'une quelconque des revendications précédentes.

17. Outil de coupe ou de forage incorporant au moins un élément super-abrasif selon la revendication 16.

18. Procédé permettant de produire un outil de coupe ou de forage selon la revendication 17, ledit élément super-abrasif étant fixé sur un substrat d'outil en mouillant la seconde couche protectrice du revêtement avec un métal fondu.

19. Procédé selon la revendication 18, ledit métal étant choisi dans le groupe comprenant : le cobalt, le nickel, le fer, le cuivre, le titane, l'argent, l'or, l'aluminium, l'indium et des alliages contenant au moins deux de ces métaux.

20. Procédé selon la revendication 18 ou 19, ledit métal fondu étant appliqué par infiltration, coulage, brasage fort, pulvérisation, soudage, brasage tendre, compression isostatique à chaud (PIC) ou cyclage haute température haute pression (HTHP).

21. Procédé d'application d'un revêtement à un substrat comprenant du diamant mono ou polycristallin ou un matériau contenant du diamant, une première couche adhésive étant formée directement sur le substrat par une première phase de procédé de dépôt chimique, ladite première couche comprenant un mélange de tungstène et de carbure de tungstène allié avec du fluor en une quantité de 0,001 à 0,12 % en poids calculée sur le poids total de la première couche et une seconde couche protectrice étant formée sur la première couche par une seconde phase de procédé de dépôt chimique, ladite seconde couche comprenant au moins du tungstène allié avec du fluor en une quantité de 0,001 à 0,12 % en poids calculée sur le poids total de la seconde couche.

22. Procédé selon la revendication 21, ladite première phase de procédé de dépôt chimique comprenant soit :
i) la mise en place du substrat dans un milieu de poudre solide exempte de carbone comprenant de la poudre de tungstène métallique et des fluorures en une quantité de 0,1 à 10 % en poids, le chauffage sous vide ou sous atmosphère de gaz inerte et le maintien d'une température de 800 à 1050°C pendant au moins 10 minutes afin de former la première couche adhésive ; soit
ii) la mise en place du substrat dans un milieu gazeux comprenant du WF₆ et de l'hydrogène dans un rapport volumétrique de l'hexafluorure de tungstène sur l'hydrogène allant de 0,6 à 0,1, à une température de 400 à 600°C et une pression de 0,5 à 20 kPa pendant au moins 2 minutes afin de produire une couche de tungstène allié avec du fluor en une quantité de 0,001 à 0,12 % en poids, avec une épaisseur d'au moins 0,1 µm, suivie d'un traitement thermique à une température comprise entre 800°C et 1000°C pendant au moins 10 minutes afin de former la première couche adhésive.

23. Procédé selon la revendication 22, ladite couche de tungstène allié avec du fluor étant appliquée à une épaisseur allant jusqu'à 100 µm.

24. Procédé selon la revendication 22 ou 23, ladite seconde phase de procédé de dépôt chimique comprenant la mise en place du substrat revêtu avec la première couche adhésive dans un milieu gazeux comprenant du WF₆, de l'hydrogène et éventuellement des hydrocarbures, à une température de 350 à 600°C et une pression partielle de 0,1 à 20 kPa pendant au moins 10 minutes afin de former la seconde couche protectrice.

25. Procédé selon l'une quelconque des revendications 21 à 24, au moins l'un desdits revêtements étant déposé par dépôt en phase vapeur, la vapeur étant non ionisée et active chimiquement au cours du procédé de dépôt, le substrat étant déplacé au cours du procédé de dépôt de façon à obtenir un revêtement complet sur toute la surface du substrat.
